# DEMANDE DE BREVET EUROPEEN

(11) **EP 1 367 714 A1**
(43) Date de publication de la demande: **03.12.2003**
(21) Numéro de dépôt: 03354046.9
(22) Date de dépôt: 26.05.2003
(51) Int. Cl.: H03H 7/48, H03H 7/12

(54) **Coupleur haute frequence**

(30) Priorité: 28.05.2002 FR 0206525
(71) Demandeur: STMicroelectronics S.A., 92120 Montrouge (FR)
(72) Inventeur: Bremond, André, 37270 Veretz (FR); Dupont, Francois, 37000 Tours (FR)
(74) Mandataire: de Beaumont, Michel

(57) **Abrégé**

L'invention concerne un coupleur (10) haute fréquence pour extraire un signal secondaire représentatif d'un signal principal véhiculé par une ligne conductrice (9), comprenant deux filtres respectivement passe-haut (11) et passe-bas (12) associés en série et dont l'entrée (E1) est destinée à être reliée à ladite ligne (9) tandis que la sortie (O2) est destinée à fournir le signal secondaire, les filtres étant dimensionnés de sorte que la somme de leur atténuations respectives soit sensiblement constante sur la bande passante du coupleur, et que leurs fréquences de coupure respectives soient dans ladite bande passante

## Description

La présente invention concerne les coupleurs haute fréquence qui sont intercalés entre un amplificateur de puissance et une antenne dans une chaîne d'émission radiofréquence. De tels coupleurs servent à extraire une partie du signal transmis vers l'antenne afin, par exemple, de permettre une mesure de son intensité et d'adapter en conséquence la puissance de l'amplificateur.

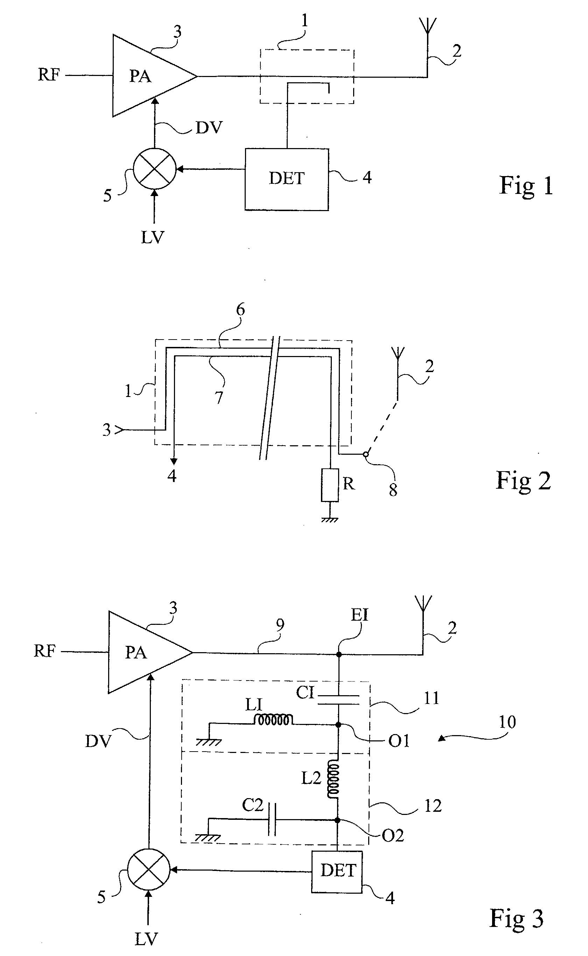

La figure 1 représente, de façon partielle et schématique, un exemple classique de circuit d'émission radiofréquence comportant un coupleur 1 du type auquel s'applique la présente invention.

Le circuit d'émission est généralement contenu dans un circuit ou tête d'émission-réception radiofréquence comprenant une chaîne de réception et une chaîne d'émission depuis une même antenne 2. En figure 1, on ne considère que le circuit d'émission, un séparateur (non représenté) étant généralement prévu en entrée de l'antenne 2 pour distinguer les signaux émis des signaux reçus.

Un signal radiofréquence (RF) porté par une fréquence dans une bande prédéfinie est appliqué en entrée d'un amplificateur de puissance 3 (PA) dont la sortie est reliée à l'antenne 2. Le coupleur 1 est intercalé entre l'amplificateur 3 et l'antenne 2 pour prélever un signal proportionnel au signal émis. Le signal extrait par le coupleur 1 est, par exemple, fourni en entrée d'un détecteur 4 (DET), généralement un détecteur de valeur crête ou de valeur moyenne, chargé de mesurer l'intensité du signal. Une sortie du détecteur 4 est combinée (comparateur 5) avec un seuil de puissance requis LV pour fournir une commande de niveau DV à l'amplificateur 3. Le coupleur 1, le détecteur 4 et le comparateur 5 constituent une boucle d'asservissement de la puissance de l'amplificateur d'émission sur la consigne LV.

La consigne LV peut, selon l'application, être prédéterminée ou être fournie par des circuits externes au système d'émission-réception. Par exemple, dans une application à la téléphonie mobile, le niveau de puissance requis est généralement fourni lors de l'établissement de la communication, puis périodiquement, par une balise à laquelle se trouve connecté le module. En fait, lors de l'établissement d'une communication, le circuit d'émission émet à pleine puissance. Cette puissance est mesurée par la balise recevant les signaux qui émet en retour, à destination du téléphone, une consigne de puissance pour la suite de la communication.

La figure 2 représente, de façon schématique, une structure classique d'un coupleur 1 utilisé dans une chaîne d'émission telle qu'illustrée par la figure 1. Il s'agit d'un coupleur électromagnétique utilisant deux pistes 6 et 7 généralement dessinées sur un circuit imprimé ou intégré et couplées l'une à l'autre. Une extrémité d'une première piste 6 est reliée en sortie de l'amplificateur 3 tandis qu'une autre extrémité 8 est destinée à être reliée à l'antenne 2 (généralement par l'intermédiaire du séparateur de bandes). Une deuxième piste 7 a une première extrémité reliée à l'entrée du détecteur 4 et une deuxième extrémité reliée à la masse, généralement par une résistance R. La forme donnée à la piste 6 à l'intérieur du coupleur 1 est, en plan, une forme d'arche(s) à l'intérieur de laquelle vient se loger, par des tronçons parallèles, la deuxième piste 7. La circulation d'un signal dans la première piste 6 engendre, par induction, un signal proportionnel dans la deuxième piste 7. Ce signal peut alors être mesuré par le détecteur 4.

Un inconvénient d'un coupleur inductif tel qu'illustré par la figure 2 est qu'il est sélectif en fréquence. En effet, le coupleur est dimensionné en fonction des fréquences qu'il doit être capable d'extraire. En pratique, dans une application au téléphone, cela conduit à devoir prévoir un coupleur pour la bande dite DCS ou PCS autour de 1800 MHz et un coupleur pour la bande dite GSM autour de 900 MHz. Le recours à deux coupleurs nuit à la miniaturisation recherchée des systèmes d'émission radiofréquence. En pratique, compte tenu des fréquences utilisées, les pistes d'un coupleur inductif ont plusieurs centimètres (par exemple, de l'ordre de 3 cm) de longueur déployée. De plus, si on souhaite réduire la surface occupée par le coupleur, on se trouve confronté à un problème d'épaisseur des pistes du coupleur.

La présente invention vise à proposer un coupleur haute fréquence intégré qui pallie les inconvénients des coupleurs classiques.

L'invention vise, plus particulièrement, à proposer un coupleur haute fréquence dont l'encombrement en surface soit réduit par rapport au coupleur à induction.

L'invention vise également à ce que cette réduction de surface ne se traduise pas par une augmentation d'épaisseur du circuit contenant le coupleur.

L'invention vise également à proposer un coupleur large bande.

Dans un exemple d'application au téléphone mobile, l'invention vise notamment à proposer un coupleur qui puisse fonctionner dans toute la gamme des fréquences utilisées.

Pour atteindre ces objets et d'autres, la présente invention prévoit un coupleur haute fréquence pour extraire un signal secondaire représentatif d'un signal principal véhiculé par une ligne conductrice, comprenant deux filtres respectivement passe-haut et passe-bas associés en série et dont l'entrée est destinée à être reliée à ladite ligne tandis que la sortie est destinée à fournir le signal secondaire, les filtres étant dimensionnés de sorte que la somme de leur atténuations respectives soit sensiblement constante sur la bande passante du coupleur, et que leurs fréquences de coupure respectives soient dans ladite bande passante.

Selon un mode de réalisation de la présente invention, la somme des atténuations respectives des filtres est constante à plus ou moins 10 % sur la bande passante du coupleur.

Selon un mode de réalisation de la présente invention, le couplage est de type capacitif.

Selon un mode de réalisation de la présente invention, le filtre passe-haut a son entrée reliée à l'entrée du coupleur.

Selon un mode de réalisation de la présente invention, chaque filtre comporte une seule cellule inductive et capacitive.

Selon un mode de réalisation de la présente invention, le coupleur est réalisé en circuit intégré.

Selon un mode de réalisation de la présente invention, le filtre passe-haut comporte un condensateur de valeur comprise entre 0,1 picofarad et 50 picofarads et une inductance de valeur comprise entre 0,1 nanohenry et 50 nanohenrys.

Selon un mode de réalisation de la présente invention, le filtre passe-bas comporte un condensateur de valeur comprise entre 10 femtofarads et 100 picofarads et une inductance de valeur comprise entre 0,1 nanohenry et 50 nanohenrys.

Selon un mode de réalisation de la présente invention, le coupleur est appliqué à l'extraction d'un signal d'asservissement d'un amplificateur de puissance d'un circuit d'émission radiofréquence.

La présente invention vise aussi un circuit d'émission radiofréquence large bande, comportant, entre un amplificateur d'émission et une antenne, un coupleur tel que ci-dessus.

La présente invention vise aussi un téléphone portable contenant un circuit tel que ci-dessus.

Ces objets, caractéristiques et avantages, ainsi que d'autres de la présente invention seront exposés en détail dans la description suivante de modes de réalisation particuliers faite à titre non limitatif en relation avec les figures jointes parmi lesquelles :
la figure 1 décrite précédemment représente un exemple classique de circuit d'émission du type auquel s'applique la présente invention ;
la figure 2 illustre la réalisation pratique d'un coupleur inductif classique ;
la figure 3 représente, de façon très schématique, un circuit d'émission selon un mode de réalisation de la présente invention ;
la figure 4 illustre, par une courbe représentant le gain en fonction de la fréquence, le fonctionnement du coupleur de la figure 3 ; et
la figure 5 représente, sous forme de blocs, un exemple d'application du coupleur de l'invention à une détection d'accord de l'antenne d'un circuit d'émission radiofréquence.

De mêmes éléments ont été désignés par les mêmes références aux différentes figures. Pour des raisons de clarté, seuls les éléments du circuit d'émission qui sont nécessaires à la compréhension de l'invention ont été représentés aux figures et seront décrits par la suite. En particulier, les circuits amont d'un amplificateur de puissance d'émission n'ont pas été illustrés. L'invention s'applique quelle que soit la chaîne d'émission prévue en amont de l'amplificateur de puissance et du coupleur associé. De même, les circuits d'exploitation des mesures effectuées par un coupleur selon l'invention n'ont pas été détaillés et se déduisent des circuits de détection utilisés classiquement. L'invention s'applique à toute utilisation d'un coupleur.

Une caractéristique de la présente invention est de réaliser un coupleur au moyen de deux structures de filtres respectivement passe-haut et passe-bas dimensionnés pour obtenir une réponse en fréquence élargie et la plus constante possible.

La figure 3 représente, par une vue schématique, un mode de réalisation d'un coupleur 10 selon l'invention, intégré dans un circuit d'émission radiofréquence.

Un amplificateur de puissance 3 (PA) reçoit un signal radiofréquence RF à émettre et sa sortie est reliée à une antenne d'émission 2 (le cas échéant par l'intermédiaire d'un séparateur de bandes). L'amplificateur 3 est commandé par un signal DV de réglage de puissance fourni par un comparateur 5 entre un niveau de consigne LV et un niveau mesuré fourni, dans cet exemple, par un détecteur 4 (DET) de valeur crête ou de valeur moyenne. Jusque là, le circuit d'émission reprend les éléments d'un circuit classique.

Selon l'invention, le coupleur 10 comporte une première structure 11 de filtrage passe-haut suivie d'une deuxième structure 12 de filtrage passe-bas. Les structures 11 et 12 sont des structures inductives et capacitives constituées chacune au minimum d'une cellule de filtrage, c'est-à-dire d'un condensateur et d'une inductance.

Dans l'exemple de la figure 3, la structure 11 de filtrage passe-haut est constituée d'un condensateur C1 et d'une inductance L1. L'inductance L1 est reliée entre la masse et une borne O1 de sortie du filtre 11. Le condensateur C1 est relié entre une borne E1 d'entrée du filtre 11 et la borne O1, la borne E1 étant connectée à la ligne 9 reliant l'amplificateur 3 à l'antenne 2.

La structure 12 de filtrage passe-bas est constituée d'une inductance L2 et d'un condensateur C2. L'inductance L2 est reliée entre la borne de sortie O1 du filtre 11 et une borne 02 de sortie de la structure passe-bas 12, reliée à l'entrée du détecteur 4. Le condensateur C2 est relié entre la borne 02 et la masse.

Selon l'invention, les deux structures sont en série et la structure passe-haut 11 est connectée côté ligne 9 de liaison de l'amplificateur 3 à l'antenne 2, de façon à bénéficier d'un couplage capacitif par le condensateur C1.

Les valeurs des constituants des structures 11 et 12 sont choisies, en fonction de la bande passante souhaitée, pour que :
- la somme des atténuations respectives des filtres passe-haut et passe-bas (donnant l'atténuation du coupleur 10) soit sensiblement constante dans la bande passante souhaitée ; et
- les fréquences de coupure respectives (fréquences pour lesquelles l'atténuation est de -20 dB) des filtres passe-haut et passe-bas soient situées dans cette bande passante, de façon à obtenir des réponses croisées en fréquence.

Par atténuation sensiblement constante, on considère de préférence une atténuation constante à plus ou moins 10%.

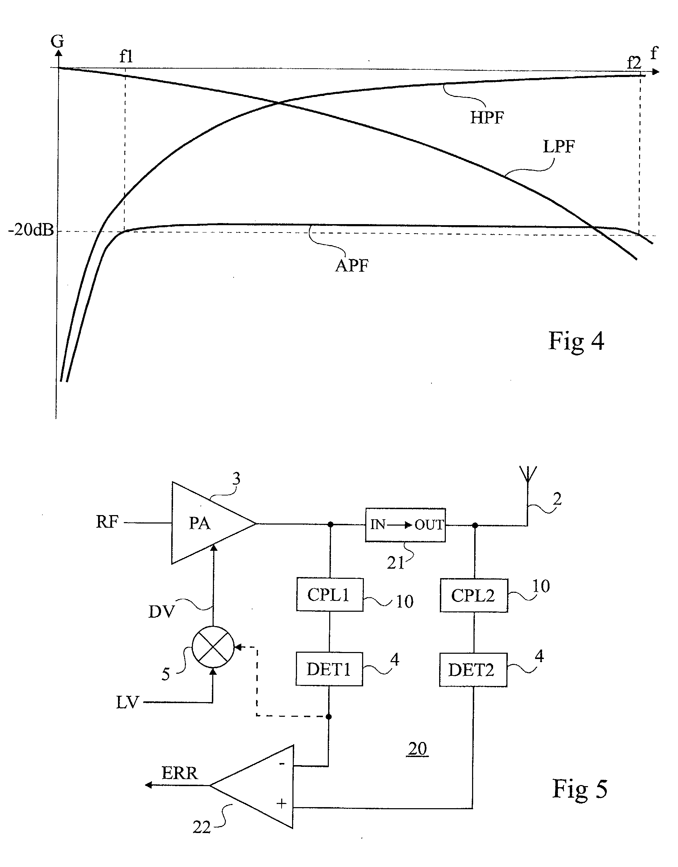

La figure 4 illustre, par une caractéristique gain G en fonction de la fréquence f, les réponses respectives des structures 11 et 12 de la figure 3 pour obtenir un coupleur selon l'invention. On considère, par exemple, une bande passante du coupleur (APF) comprise entre des fréquences f1 et f2. Dans l'exemple représenté, les fréquences de coupure respectives des filtres passe-bas (LPF) et passe-haut (HPF) sont situées à l'extérieur de la bande passante du coupleur. Cela n'est toutefois pas obligatoire.

Comme l'illustre la figure 4, la courbe APF résultant de l'association des structures 11 et 12 est sensiblement constante entre les fréquences f1 et f2.

De préférence, on recherche une bande passante la plus large possible de façon à obtenir en quelque sorte un filtre passe-tout de réponse stable.

Selon l'invention, le filtre passe-haut constitutif du coupleur est choisi pour avoir des pertes d'insertion relativement élevées dans la mesure où le signal que doit fournir le coupleur est un signal proportionnel, mais de puissance nettement inférieure au signal transmis à l'antenne. Cette caractéristique de filtre est contraire à ce que l'on recherche habituellement pour du filtrage. Ce choix contribue à minimiser les pertes dans la structure d'émission. Toutefois, le couplage, donc les pertes d'insertion, de la structure passe-haut doit être compatible avec l'obtention d'un signal exploitable, c'est-à-dire lisible par le détecteur 4. Par exemple, on cherche à obtenir un signal résultant (APF) atténué de l'ordre de -15 à -20 dB par rapport au signal fourni à l'antenne. Le choix de l'atténuation est un compromis entre la sensibilité du détecteur 4 et une volonté de ne pas perturber l'émission par un prélèvement de signal trop important.

Selon une variante de réalisation, on prévoit plusieurs cellules de filtrage pour les structures respectives passe-haut et/ou passe-bas. La multiplication du nombre de cellules permet d'obtenir une réponse plus plate du coupleur au prix cependant d'un encombrement légèrement plus important.

Un avantage de la présente invention est qu'elle diminue considérablement l'encombrement d'un coupleur par rapport au coupleur électromagnétique classique. En particulier, en reprenant l'exemple d'application à un téléphone mobile multi-bandes, l'invention permet un gain de place, même en prévoyant un coupleur par bande de fréquences.

Un autre avantage de l'invention est, en relation avec l'application à des téléphones mobiles, de permettre l'utilisation d'un unique coupleur multi-bandes en raison de la large bande de fréquences (donc de la faible sélectivité) du coupleur de l'invention.

Pour obtenir ce résultat, on tire profit du fait que l'on fonctionne à des fréquences élevées (plusieurs dizaines de MHz), ce qui permet l'emploi d'inductances L1 et L2 de valeurs relativement faibles, donc peu encombrantes.

A titre d'exemple particulier de réalisation, on donnera ci-après trois dimensionnements possibles pour trois bandes passantes différentes de coupleur selon l'invention.
Exemple 1, bande passante comprise entre 200 et 800 MHz :
L1 = 19,5 nanohenrys,
C1 = 6 picofarads,
L2 = 10,2 nanohenrys, et
C2 = 39 picofarads.
Exemple 2, bande passante comprise entre 900 MHz et 2,1 GHz :
L1 = 11,5 nanohenrys,
C1 = 0,5 picofarad,
L2 = 0,9 nanohenry, et
C2 = 3,6 picofarads.
Exemple 3, bande passante comprise entre 3 et 5 GHz :
L1 = 1 nanohenry,
C1 = 18 picofarads,
L2 = 9,8 nanohenrys, et
C2 = 120 femtofarads.

La figure 5 représente un exemple d'application de la présente invention à une détection de puissance réfléchie dans un circuit d'émission. Une telle application permet d'obtenir une information sur l'accord de l'antenne 2 à la fréquence d'émission considérée. Dans le schéma de la figure 5, on s'est contenté d'intercaler, dans un schéma similaire à celui de la figure 3, un circuit 20 de détection d'accord selon l'invention. On notera que, en pratique, le circuit 20 n'est pas nécessairement directement relié en sortie de l'amplificateur 3 et en entrée de l'antenne 2. C'est pourquoi, on a représenté ces liaisons par des pointillés. En particulier, côté antenne 2, on trouvera généralement un circuit d'accord ou un sélecteur de bande réglable (par exemple commandé en fonction des résultats de la détection opérée par le circuit 20).

Le circuit 20 comprend, selon ce mode de réalisation de l'invention, deux coupleurs 10 (CPL1, CPL2) tels que décrits en relation avec la figure 3 en série avec deux détecteurs 4 (DET1, DET2), et un circuit d'isolement unidirectionnel 21 constitué, par exemple, d'éléments magnétiques.

Un premier coupleur CPL1 a son entrée reliée à l'entrée de l'isolateur 21, c'est-à-dire à la sortie de l'amplificateur 3. Un deuxième coupleur CPL2 a son entrée reliée à la sortie de l'isolateur 21, c'est-à-dire côté antenne 2. Les sorties respectives des coupleurs CPL1 et CPL2 sont reliées (après redressement par les détecteurs 4) aux entrées respectives d'un amplificateur opérationnel 22, dont la sortie fournit un signal ERR de désaccord éventuel de l'antenne 2.

Si la tension redressée en sortie du coupleur CPL2 est différente de la tension redressée en sortie du coupleur CPL1, cela signifie qu'il y a un problème d'accord de l'antenne par rapport à la fréquence du signal émis. Un tel circuit 20 permet donc de détecter, de façon particulièrement simple, un désaccord de l'antenne.

On notera qu'en cas d'utilisation d'un circuit 21 tel qu'illustré par la figure 5, l'un des deux coupleurs (par exemple le coupleur CPL1) peut également servir à l'asservissement de la puissance de l'amplificateur 3. Dans ce cas (illustré par une liaison en pointillés), la sortie du détecteur DET1 est reliée à un comparateur 5 recevant une consigne de niveau LV fournissant le signal d'asservissement DV à l'amplificateur 3.

Bien entendu, la présente invention est susceptible de diverses variantes et modifications qui apparaîtront à l'homme de l'art. En particulier, les dimensionnements respectifs des structures passe-haut et passe-bas constitutives d'un coupleur selon l'invention sont à la portée de l'homme du métier à partir de la bande passante souhaitée et des indications fonctionnelles données ci-dessus. De préférence, les valeurs respectives des condensateurs et inductances sont comprises entre les limites suivantes:
C1 entre 0,1 et 50 picofarads ;
C2 entre 10 femtofarads et 100 picofarads ; et
L1 et L2 entre 0,1 et 50 nanohenrys.

De plus, l'exploitation des signaux fournis par un coupleur selon l'invention, que ce soit dans un but d'asservissement d'un amplificateur de puissance, dans un but de détection de désaccord, ou dans un autre but classique, est à la portée de l'homme du métier.

En outre, on notera que si l'invention a été décrite plus particulièrement en relation avec une application à la téléphonie mobile et à l'accord d'un amplificateur de puissance d'un circuit d'émission, elle s'applique plus généralement dès que l'on souhaite disposer d'un coupleur haute fréquence intégré et préférentiellement large bande sur une liaison matérielle véhiculant un signal haute fréquence (supérieure à 10 MHz). Par exemple, l'invention s'applique à des coupleurs destinés à des signaux selon les normes CDMA ou WCDMA.

## Revendications

1. Coupleur (10) haute fréquence pour extraire un signal secondaire représentatif d'un signal principal véhiculé par une ligne conductrice (9), **caractérisé en ce qu'**il comprend deux filtres respectivement passe-haut (11) et passe-bas (12) associés en série et dont l'entrée (E1) est destinée à être reliée à ladite ligne (9) tandis que la sortie (02) est destinée à fournir le signal secondaire, les filtres étant dimensionnés de sorte que la somme de leur atténuations respectives soit sensiblement constante sur la bande passante du coupleur, et que leurs fréquences de coupure respectives soient dans ladite bande passante.

2. Coupleur (10) selon la revendication 1, dans lequel la somme des atténuations respectives des filtres est constante à plus ou moins 10 % sur la bande passante du coupleur.

3. Coupleur selon la revendication 1 ou 2, dans lequel le couplage est de type capacitif.

4. Coupleur selon la revendication 3, dans lequel le filtre passe-haut (11) a son entrée (E1) reliée à l'entrée du coupleur.

5. Coupleur selon l'une quelconque des revendications 1 à 4, dans lequel chaque filtre (11, 12) comporte une seule cellule inductive et capacitive.

6. Coupleur selon l'une quelconque des revendications 1 à 5, réalisé en circuit intégré.

7. Coupleur selon l'une quelconque des revendications 1 à 6, dans lequel le filtre passe-haut (11) comporte un condensateur (C1) de valeur comprise entre 0,1 picofarad et 50 picofarads et une inductance (L1) de valeur comprise entre 0,1 nanohenry et 50 nanohenrys.

8. Coupleur selon l'une quelconque des revendications 1 à 7, dans lequel le filtre passe-bas (12) comporte un condensateur (C2) de valeur comprise entre 10 femtofarads et 100 picofarads et une inductance (L2) de valeur comprise entre 0,1 nanohenry et 50 nanohenrys.

9. Coupleur selon l'une quelconque des revendications 1 à 8, appliqué à l'extraction d'un signal d'asservissement d'un amplificateur de puissance (3) d'un circuit d'émission radiofréquence.

10. Circuit d'émission radiofréquence large bande, comportant, entre un amplificateur d'émission (3) et une antenne (2), un coupleur selon l'une quelconque des revendications 1 à 9.

11. Téléphone portable contenant un circuit selon la revendication 10.
